# EUROPEAN PATENT SPECIFICATION

(11) **EP 0 526 513 B1**
(45) Date of publication and mention of the grant of the patent: **24.07.1996**
(21) Application number: 91908205.7
(22) Date of filing: 26.04.1991
(51) Int. Cl.: G01R 33/38

(54) **MAGNETIC FIELD GENERATING ASSEMBLY**
VORRICHTUNG ZUM ERZEUGEN VON MAGNETFELDERN
ENSEMBLE GENERATEUR DE CHAMP MAGNETIQUE

(30) Priority: 27.04.1990 GB 9009579
(43) Date of publication of application: 10.02.1993
(73) Proprietor: OXFORD MEDICAL LIMITED, Osney Mead, Oxford, OX2 0DX (GB); E.I. DU PONT DE NEMOURS AND COMPANY, Wilmington Delaware 19898 (US)
(72) Inventor: MCDOUGALL, Ian, Leitch, Charlbury Oxon OX7 3EL (GB); ARMSTRONG, Alan, George, Marcel, Bladon Oxon OX7 3LE (GB)
(74) Representative: Skone James, Robert Edmund
(86) International application number: GB9100664
(87) International publication number: WO9117455

(56) References cited:
- EP-A- 0 217 520
- EP-A- 0 245 755
- WO-A-90/04258
- DE-A- 3 814 260
- US-A- 4 728 895

## Description

The invention relates to a magnetic field generating assembly, for example for use in nuclear magnetic resonance (NMR) apparatus.

Conventional NMR apparatus has a large solenoidal magnet which generates a high strength magnetic field within its bore with, at the centre of the bore, a working region in which the magnetic field strength is substantially uniform. In order to perform an experiment, a gradient coil system is provided, usually formed by resistive conductors, to superimpose magnetic gradients on the fields within the working region. The gradient coil system is positioned within the bore of the magnet which, in order to allow enough space for a human body, has to be of a relatively large diameter.

We have proposed alternative magnetic field generating assemblies in which the working volume is more easily accessible. An example of such an assembly is a C-shaped magnet. The advantage of this "open access" type of magnet is that a patient does not have to be fully positioned within the bore of a magnet while at the same time access to the patient or other object is relatively easy during performance of the experiment.

We have now devised a further improvement in which a magnetic field generator assembly according to the present invention comprises primary magnetic field generating means having at least one pole face beyond which is generated a magnetic field, the field being substantially uniform within a working volume; and gradient magnetic field generating means for superposing a gradient magnetic field on the magnetic field within the working volume, all of the gradient magnetic field generating means being positioned behind the or each pole face of the primary magnetic field generating means.

We have found that it is possible to incorporate all of the gradient magnetic field generating means in regions behind the or each pole face of the primary magnetic field generating means.

It is envisaged that the primary magnetic field generating means could generate the uniform or homogeneous region in a volume spaced from the volume defined by the primary magnetic field generating means itself. Indeed, a movable probe could be constructed comprising both the primary and gradient magnetic field generating means. These arrangements would be particularly useful for examining large objects.

The invention is particularly applicable where the working region is defined between opposed pole faces of the primary magnetic field generating means. This leads to the advantage that no part of the gap between the pole faces is occupied by the magnetic field generating means thus increasing the volume that can be used for the object to be imaged. Consequently the pole faces can be positioned relatively close together compared with previous arrangements enabling the amount of magnetic material necessary to produce a given operating field to be reduced to an absolute minimum. Indeed, the invention leads to a construction in which the pole faces can be placed virtually in contact with the object to be examined so as to provide high gradient strength and rapid switching rate.

Preferably, the primary magnetic field generating means comprises a number of magnetic field generators, for example a set of permanent magnets of ferrite.

The use of permanent magnets for the primary magnetic field generating means enables the gradient magnetic field generating means to be in the form of one or more coils which can be threaded around and/or between the generators of the first magnetic field generating means. This enables problems with the return arc of the gradient magnetic field coils to be overcome since these may be situated in any position and both active and return arcs can be placed with the maximum degree of freedom to maximise the purity of the gradient field. Furthermore, the use of permanent magnets means that eddy current problems are not incurred.

Typically, the gradient magnetic field generating means will comprise three sets of gradient magnetic field coils for generating three orthogonal magnetic field gradients.

The invention is particularly suited for use with a C-shaped magnet.

In general, the pole faces will be fixed relative to one another. However it is possible for the pole faces including the primary magnetic field generating means and gradient magnetic field generating means to be movably mounted so they can be brought close to or even touch a sample between then.

The invention can be applied in a wide variety of fields including not only whole body, body parts, and animal nuclear magnetic resonance imaging but also other industrial and commercial applications involving the identification, characterization, measurement, quality assurance and control of materials, components, and assemblies. While not intended to be exhaustive, some specific examples of these applications could be identification of drugs or explosives, characterization of green body ceramics, measurement of oil saturation and permeability in drilled cores, quality assurance in polymer and ceramic processing, and quality control in foodstuffs or laminate or fiber reinforced composites.

An example of a C-shaped magnet according to the invention will now be described with reference to the accompanying drawings, in which:-
Figure 1 is a side view of the magnet illustrating schematically the gradient coils;
Figure 2 is an end view of the magnet; and,
Figure 3 illustrates schematically an aerofoil positioned between the pole pieces of the magnet.

The magnet shown in the drawings comprises a C-shaped yoke 1 with a pair of pole pieces 2, 3 mounted on inner surfaces of the arms of the yoke 1 so as to face each other. Each pole piece 2, 3 contains a large number of small, permanent, electrically insulating (such as ferrite) magnets (not shown). The magnets are arranged so as to generate within a working volume 4 at the geometric centre between the pole pieces 2, 3 a relatively high strength, uniform magnetic field suitable for NMR.

In order to perform an NMR experiment, it is necessary to superimpose on the uniform field within the working region 4 a series of magnetic field gradients which are rapidly switched in direction. Conventionally, these gradients are arranged to lie in orthogonal X, Y, and Z directions as shown in the drawings. To achieve this, each pole piece 2, 3 is provided with a set of three gradient coils.

A first set of gradient coils 5, 6 extend around the ends of the volume defined by the permanent magnets with the turns of each coil being substantially parallel to the X, Y plane so that a gradient can be generated in the Z direction.

A second set of gradient coils 7, 8 having rectangularly shaped turns extend with the planes of the turns substantially parallel with the XZ plane so as to generate a magnetic field gradient in the Y direction.

A third set of gradient magnetic field coils 9, 10 are provided having a similar form to the coils 7, 8 but extending orthogonal to those coils with the rectangular turns in the YZ plane so as to generate a gradient magnetic field in the X direction.

It will be noted that the active arcs of each of the gradient coils are positioned just behind the pole faces and close to the working volume 4.

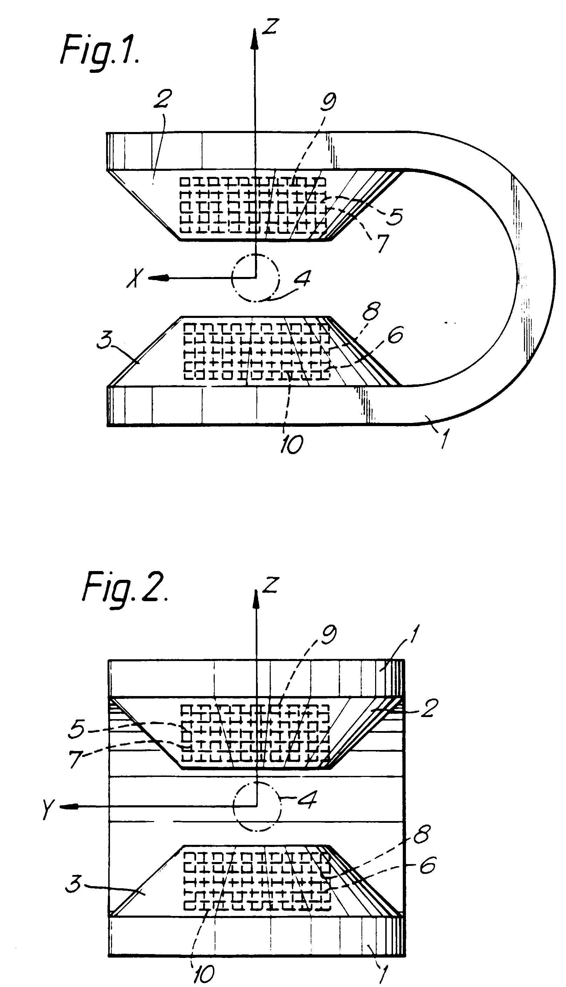

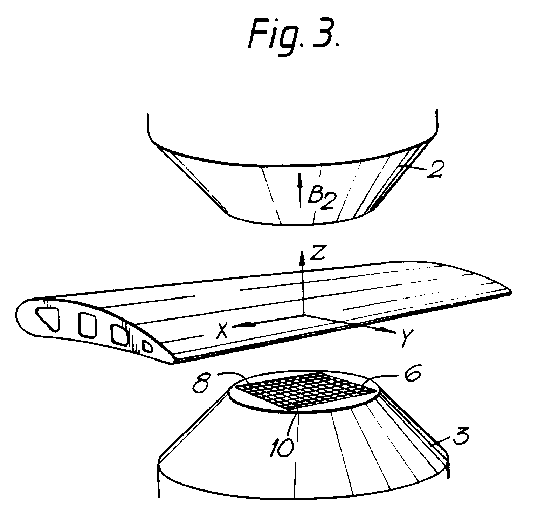

Figure 3 illustrates the magnet of Figures 1 and 2 being used to investigate, using NMR, an aerofoil 11 positioned between the pole pieces 2, 3.

We have conducted a series of experiments to look at the effect on inductance in a coil of various magnetic elements to assess what effect if any the ferrite permanent magnets will have on the gradient coils.

A floppy wire coil was measured to have an inductance of between 666 and 678 µH depending on how much it was squeezed. When a simulated double E yoke was set up around the coil using bundles of iron shims the inductance increased to 1036 µH. A short tunnel of four ferrite Ceramic 8 blocks around part of the coil produced an inductance of 685 µH.

Six ferrite blocks in the middle of the coil lead to an inductance of 682 µH. An iron sheet of approximately 14 swg under the coil lead to an inductance of 590 µH. A coil sandwiched between two iron sheets lead to an inductance of 522 µH. A coil arranged with its plane perpendicular to the two iron sheets lead to an inductance of 667 µH. A coil with its plane perpendicular to a twelve millimetre thick aluminium sheet lead to an inductance of 604 µH and a coil with its plane parallel to an touching the aluminium sheet lead to an inductance of 364µH.

The conclusion is that ferrite has no detrimental effect on the coil and that iron eddy currents are only problematic for a coil parallel and close to the iron.

## Claims

1. A magnetic field generator assembly comprising primary magnetic field generating means having at least one pole face beyond which is generated a magnetic field, the field being substantially uniform within a working volume; and gradient magnetic field generating means for superposing a gradient magnetic field on the magnetic field within the working volume, all of the gradient magnetic field generating means being positioned behind the or each pole face of the primary magnetic field generating means.

2. An assembly according to claim 1, wherein the primary magnetic field generating means and the gradient magnetic field generating means are mounted on a movable probe.

3. An assembly according to any of the preceding claims, wherein the working region is defined between opposed pole faces of the primary magnetic field generating means.

4. An assembly according to any of the preceding claims, wherein the primary magnetic field generating means comprises a C-shaped magnet.

5. An assembly according to any of the preceding claims, wherein the primary magnetic field generating means comprises a set of permanent magnets.

6. An assembly according to any of the preceding claims, wherein the gradient magnetic field generating means comprises a number of electrical coils.

7. An assembly according to claim 6, when dependent on claim 5, wherein the coils are threaded around, and or between the permanent magnets.

8. Nuclear magnetic resonance apparatus incorporating a magnetic field generating assembly according to any of the preceding claims.

## Patentansprüche

1. Eine Magnetfelderzeugungsvorrichtung umfassend eine Primärmagnetfelderzeugungseinrichtung mit wenigstens einer Polfläche, jenseits der ein Magnetfeld erzeugt wird, wobei das Magnetfeld innerhalb eines Arbeitsvolumens im wesentlichen uniform ist; und eine Gradientenmagnetfelderzeugungseinrichtung zum Überlagern eines Gradientenmagnetfelds mit dem Magnetfeld innerhalb des Arbeitsvolumens, wobei die gesamte Gradientenmagnetfelderzeugungseinrichtung hinter der oder jeder Polfläche der Primärmagnetfelderzeugungsvorrichtung positioniert ist.

2. Eine Vorrichtung nach Anspruch 1, in welcher die Primärmagnetfelderzeugungseinrichtung und die Gradientenmagnetfelderzeugungseinrichtung auf einer bewegbaren Sonde angebracht sind.

3. Eine Vorrichtung nach einem der vorangegangenen Ansprüche, in welcher der Arbeitsbereich zwischen einander gegenüberliegenden Polflächen der Primärmagnetfelderzeugungseinrichtung definiert ist.

4. Eine Vorrichtung nach einem der vorangegangenen Ansprüche, in welcher die Primärmagnetfelderzeugungseinrichtung einen C-förmigen Magneten umfaßt.

5. Eine Vorrichtung nach einem der vorangegangenen Ansprüche, in welcher die Primärmagnetfelderzeugungseinrichtung einen Satz Permanentmagneten umfaßt.

6. Eine Vorrichtung nach einem der vorangegangenen Ansprüche, in welcher die Gradientenmagnetfelderzeugungseinrichtung eine Anzahl elektrischer Spulen umfaßt.

7. Eine Vorrichtung nach Anspruch 6, abhängig von Anspruch 5, in welcher die Spulen um und/oder zwischen die Permanentmagneten gewickelt sind.

8. Kernspinresonanzvorrichtung, umfassend eine Magnetfelderzeugungsvorrichtung gemäß einem der vorangegangenen Ansprüche.

## Revendications

1. Ensemble générateur d'un champ magnétique comprenant un dispositif générateur d'un champ magnétique primaire ayant au moins une face polaire au-delà de laquelle est créé un champ magnétique, le champ étant pratiquement uniforme dans un volume de travail, et un dispositif générateur d'un champ magnétique de gradient destiné à superposer un champ magnétique de gradient au champ magnétique créé dans le volume de travail, tous les dispositifs générateurs d'un champ magnétique de gradient étant placés derrière la face polaire ou chaque face polaire du dispositif générateur du champ magnétique primaire.

2. Ensemble selon la revendication 1, dans lequel le dispositif générateur d'un champ magnétique primaire et le dispositif générateur d'un champ magnétique de gradient sont montés sur une sonde mobile.

3. Ensemble selon l'une quelconque des revendications précédentes, dans lequel la région de travail est délimitée entre les faces polaires opposées du dispositif générateur d'un champ magnétique primaire.

4. Ensemble selon l'une quelconque des revendications précédentes, dans lequel le dispositif générateur d'un champ magnétique primaire comporte un aimant en C.

5. Ensemble selon l'une quelconque des revendications précédentes, dans lequel le dispositif générateur d'un champ magnétique primaire comporte un ensemble d'aimants permanents.

6. Ensemble selon l'une quelconque des revendications précédentes, dans lequel le dispositif générateur d'un champ magnétique de gradient comprend un certain nombre de bobines électriques.

7. Ensemble selon la revendication 6, lorsqu'elle dépend de la revendication 5, dans lequel les bobines sont enfilées autour des aimants permanents et/ou entre ceux-ci.

8. Appareil de résonance magnétique nucléaire comprenant un ensemble générateur d'un champ magnétique selon l'une quelconque des revendications précédentes.
